Europäisches Patentamt
European Patent Office
Office européen des brevets

(19)

(11) Publication number: 0 342 009 A2

# (12) EUROPEAN PATENT APPLICATION

(21) Application number: 89304731.6

(22) Date of filing: 10.05.89

(51) Int. Cl.[4]: H 01 L 39/24

(30) Priority: 13.05.88 JP 114710/88

(43) Date of publication of application: 15.11.89 Bulletin 89/46

(84) Designated Contracting States: DE FR GB

(71) Applicant: Oki Electric Industry Company, Limited
7-12, Toranomon 1-chome Minato-ku
Tokyo 105 (JP)

(72) Inventor: Abe, Hitoshi c/o Oki Electric Industry Co., Ltd.
7-12, Toranomon 1-chome
Minato-ku Tokyo (JP)

Nakamori, Tomohiro Oki Electric Industry Co., Ltd.
7-12, Toranomon 1-chome
Minato-ku Tokyo (JP)

(74) Representative: Gaunt, Robert John et al
c/o Stevens, Hewlett & Perkins 5 Quality Court Chancery Lane
London WC2A 1HZ (GB)

## (54) Process for forming a superconducting film.

(57) An oxide superconducting film is formed by Chemical Vapor Deposition. The starting material gas sources are $Ba(DPM)_2$, $Ba(DPM)_2.(THF)_n$ or $Ba(DOM)_2.(DMF)_n$; $Cu(DPM)_2$, $Cu(DPM)_2.(THF)_n$ or $Cu(DPM)_2.(DMF)_n$; and $M(DPM)_3$, $M(DPM)_3.(THF)_n$ or $M(DPM)_3.(DMF)_n$, where;
DPM is 2,2,6,6-tetramethyl-3,5-heptaneodianate represented by the chemical formula:
$CH_3C(CH_3)_2COCHCOC(CH_3)_2CH_3$,
THF is tetrahydrofuran represented by the chemical formula:

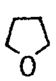

DMF is dimethylformamide represented by the chemical formula:
$HCON(CH_3)_2$
M is an element chosen from the list:
Y, La, Nd, Pm, Sm, Eu, Er, Gd, Tb, Dy, Ho, Tm, Yb, Lu,
and n is any integer. The starting material gas sources are introduced into a growth tank after gasification together with at least one of the gases $O_2$, $O_3$, or $N_2O$, and the oxide film being formed on a substrate placed in said growth tank.

EP 0 342 009 A2

## Description

# PROCESS FOR FORMING A SUPERCONDUCTING FILM

This invention concerns a process for forming oxide superconducting films (thin films), and in particular, a suitable process for forming oxide superconducting films with any desired composition and crystalline structure.

In comparison to prior-art superconductors made from materials containing Nb (nyobium), much research has been carried out recently on oxide superconductors (known as ceramic superconductors) which show superconductivity at higher temperatures. The reason for this is that if superconductivity is possible at higher temperatures, the cooling system required can be simplified, the advantages of superconductivity can easily be applied to a variety of fields, and great contributions can be made to the growth of industry. To give an example, it has been found that bulk ceramic superconductors containing sintered materials of the Y-Ba-Cu-O type show superconductivity at temperatures above that of liquid nitrogen.

If however it is desired to use oxide superconductors containing Y-Ba-Cu-O type substances in microelectronics, e.g. Josephson elements, transistors or circuit wiring, it is necessary to prepare thin films of them, and to date the only method reported for doing this was the sputter method.

The sputter method however suffered from the disadvantage that when the generation of the film is repeated, the composition of the target varies, and the composition of the thin film formed diverges widely from the composition ratio of the target.

These problems are not conductive to obtaining oxide semiconductor films with a complex and precise composition ratio.

Further, if such films are to be used in, e.g. Josephson elements, the film thickness has to be controlled at the atomic level, but this control is extremely difficult to realize with the sputter method.

Further, it is desirable that the surface of the film formed is flat down to the molecular level, but with the sputter method the desired degree of flatness is difficult to achieve.

Due to the above reasons, it was not possible using prior-art methods to obtain a high quality semiconductor film of desired composition and thickness, and excellent flatness.

An object of the invention is to eliminate the above problems.

Another object of the invention is to provide a process for forming an oxide superconducting film of excellent quality.

In order to achieve this objective, this invention uses CVD (Chemical Vapor Deposition) to form the oxide semiconducting film,
the starting material gas sources being chosen from at least one of the compounds $Ba(DPM)_2$, $Ba(DPM)_2.(THF)_n$ or $Ba(DPM)_2.(DMF)_n$, at least one of the compounds $Cu(DPM)_2$, $Cu(DPM)_2.(THF)_n$ or $Cu(DPM)_2.(DMF)_n$, and at least one of the compounds $M(DPM)_3$, $M(DPM)_3.(THF)_n$ or $M(DPM)_3.(DMF)_n$, where:
DPM is 2,2,6,6-tetramethyl-3,5-heptaneodianate represented by the chemical formula:
$CH_3C(CH_3)_2COCHCOC(CH_3)_2CH_3$,
THF is tetrahydrofuran represented by the chemical formula:

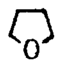

DMF is dimethylformamide represented by the chemical formula:
$HCON(CH_3)_2$
M is an element chosen from the list:
Y, La, Nd, Pm, Sm, Eu, Er, Gd, Tb, Dy, Ho, Tm, Yb, Lu,
and n is any integer,
said starting material gas sources being introduced into a growth tank after gasification together with at least one of the gases $O_2$, $O_3$, or $N_2O$, and the oxide film being formed on a substrate placed in said growth tank.

In the above method, it is convenient if the substrate upon which said semiconductor film is grown, is preheated.

Further, in the above CVD method, it is convenient if the starting material gases supplied to the growth tank are irradiated with light, if the radiant light consists of 2 or more lights with different wavelengths, and if the irradiation of the respective starting material gases is made with different lights.

It is also convenient if part or all of the $O_2$ gas in the above starting material gases is ozonized.

It is moreover convenient if the growth of the semiconductor film in said CVD method is carried out under conditions that permit it to form one molecular layer at a time.

In this construction, the CVD method is used which depends on chemical reactions. Compared to the sputter method, therefore, there is far less damage to the base layer or substrate surface in which the semiconducting film is formed, or to the surface of the insulating layer which constitutes the weak coupling of a Josephson element. As a result, the surface of the thin film after it has finished growing is extremely flat.

By suitably choosing the starting material gases, varying the conditions or order of gas supply, and varying the film growth conditions, it is possible to form a superconducting film with any desired composition and crystalline structure.

Further, by irradiating the starting material gases or by using ozonized oxygen, the starting material gases are excited, and the desired semiconducting film can be obtained even when the temperature of the growth tank is low. It is thus possible to form a semiconducting film at a temperature below the limit temperature of the heat resistance of microelectronic devices.

It is moreover possible, when growing semiconductor films by the CVD method, that the thin film

grows at the rate of one molecular layer at a time. It is thus easy to grow the film to suit the coherence length of a superconductor.

Fig. 1 is a diagram for explaining the first to third embodiments of the process for forming an oxide superconducting material film according to the invention.

Fig. 2A and Fig. 2B are diagrams showing the surface conditions of the superconducting films formed by the method of the invention and formed by the prior-art sputter method.

Fig. 3 is a diagram showing the resistance-to-temperature characteristics of the superconducting films formed by the process of the invention.

Fig. 4 is a diagram for explaining the fourth embodiment of the process of forming an oxide superconducting film according to the invention.

Fig. 5 is a diagram for explaining the fifth embodiment of the process of forming an oxide superconducting film according to the invention.

Fig. 6 is a diagram for explaining the sixth embodiment of the process of forming an oxide superconducting film according to the invention.

Fig. 7 is a diagram for explaining the seventh embodiment of the process of forming an oxide superconducting film according to the invention.

Fig. 8A and Fig. 8B are diagrams for explaining the eighth embodiment of the process of foriming an oxide superconducting film according to the invention.

Hereafter, the method of forming thin oxide superconducting films by this invention will be described with reference to the drawings.

In the following embodiments, the formation of the oxide film is described in the case of the U-Ba-Cu-O system. The method of this invention is however not limited to this example, and may be applied to oxide superconductors of other compositions by varying the starting material gases and growth conditions.

Further, the drawings used in the description give only as much detail as is necessary to explain the invention. It should therefore be understood that the dimensions and spatial relationship of each structural component are not limited to those in the diagram. Also, similar components are denoted by identical numbers.

Embodiment 1

The method of forming the superconducting film in Embodiment 1 of this invention will now be described. Fig. 1 is a block diagram of a suitable CVD apparatus for forming the film with reference to Fig. 1.

In Fig. 1, 11 is a growth tank (sometimes referred to as a reaction tube) which may be made of, for example, quartz. An induction coil 12 made of, for example, copper pipe, is would around the tank, and is connected to a high frequency (RF) power supply 13. 15 is a susceptor made of, for example, an alloy such as monel (Ni-Cu), to which a substrate 17 is previously attached. The material of substrate 17 depends on the type of oxide superconductor which it is desired to form, but may be MgO, $SrTiO_3$, $MxWO_3$, (where Mx = Li, Na or K), zirconia, or sapphire. When forming the oxide superconducting film, substrate 17 is heated to the desired temperature by high frequency induction heating with induction coil 12 and high frequency power supply 13. 19 is a thermocouple in contact with substrate 17 for monitoring its temperature, the high frequency induction heating being controlled such that this temperature reaches the desired temperature.

20 is a vacuum exhaust device which may have a similar structure to that in the prior art, and which is used to exhaust the growth tank to a suitable degree of vacuum. This exhaust device 20 is provided with a regulator to adjust the conductance along the exhaust route, and the conductance may be varied freely.

21 is a first cylinder, 23 is a 2nd cylinder and 25 is a 3rd cylinder. These cylinders 21, 23 and 25 are all connected to the growth tank 11 through respective ducts. From each of the cylinders 21, 23 and 25 in this embodiment, a carrier gas supplied via needle valves 27 and flowmeters 29. An oxygen supply duct with needle valve and flowmeter is also connected to growth tank 11 so as to supply a specified quantity of oxygen to the tank.

The starting materials for forming the oxide superconducting film in this construction are stored in cylinders - a suitable Y (yttrium) compound, e.g. $Y(DPM)_3$, in 1st cylinder 21, Ba (barium) compound, e.g. $Ba(DPM)_2$, in 2nd cylinder 23, and Cu (copper) compounds, e.g. $Cu(DPM)_2$, in 3rd cylinder 25.

DPM is 2,2,6,6-tetramethyl-3,5-heptaneodianate represented by the chemical formula:

$CH_3C(CH_3)_2COCHCOC(CH_3)_2CH_3$

These chemical compounds are solids at ordinary temperature, and are converted to gases by heating. The cylinders are therefore heated inside to adjust the vapor pressure of these gases to suitable values - cylinder 21 to 130-200°C, cylinder 23 to 230-320°C, and cylinder 25 to 130°C. Inert gases such as He, Ne, Ar, Kr, Xe and $N_2$ are also supplied as carrier gases to cylinders 21, 23 and 25, bubbled through respective cylinders, and delivered from the cylinders to growth tank 11 as starting material gases containing the corresponding element (Y, Ba or Cu).

The flowrate of each starting material gas is adjusted to the specified value by means of the needle valves 27 and flowmeters 29 attached to respective cylinders, and the delivery time of each gas is also adjusted so as to control the composition ratio of the oxide superconducting film. Oxygen may be supplied to the growth tank at a fixed rate, or may be supplied together with the starting material gases. The amount of oxygen in the film may be varied by adjusting the oxygen flowrate, adjusting the oxygen supply time, or by varying the pressure in growth tank 11 by adjusting regulator 20a of exhaust device 20.

Further, by manipulating various combinations of the valves 33 shown in Fig. 11, the order in which starting material gases are supplied to tank 11 can

be varied freely, and hence a film of desired composition and structure can be grown.

A specific example of the process followed for forming the oxide superconducting film in this embodiment will now be described.

Firstly, cylinders 21, 23 and 25 were charged respectively with starting materials $Y(DPM)_3$, $Ba(DPM)_2$ and $Cu(DPM)_2$, and the internal temperatures of the cylinders were maintained near 180°C, 300°C and 170°C respectively to convert said starting materials to gases. The flowrate of carrier gas (Ar) to each cylinder 21, 23 or 25 was set to 200 cc/min, and the flowrate of $O_2$ gas was set to 200 cc/min.

Using MgO as substrate 17, the growth surface of the oxide superconducting film was taken to be of the (100) orientation. The temperature of substrate 17, i.e. the growth temperature, was adjusted to approx. 600°C, the gases from cylinders 21, 23 and 25 together with $O_2$ gas were supplied to growth tank 11, and the film on substrate 17 was grown for approx. 30 min. When the film grown was examined with a secondary electron reflecting electron microscope (SEM), the film thickness was found to be 5µm. After growth, the substrate temperature was adjusted to 900-950°C, and $O_2$ gas was passed through continuously for several hours. After this heat treatment, the temperature was gradually lowered to room temperature, and substrate 17 was removed. The surface of the film on the substrate was then examined with a needle contact type surface roughness meter, and found to be very flat and smooth as shown in Fig. 2A. By contrast, the surface of a film prepared by the continuous sputter method was found to have considerable irregularities as shown in Fig. 2B.

Curve (a) in Fig. 3 shows the resistance - temperature characteristics of the oxide superconducting film obtained in this embodiment. As seen from this curve (a), the resistance of the film decreases with decreasing temperature and finally reaches zero in the region of 65°K.

Embodiment 2

The CVD apparatus used in this embodiment is the same as that used in Embodiment 1.

In this embodiment, the starting materials were the gas sources used in Embodiment 1, i.e. $Y(DPM)_3$, $Ba(DPM)_2$ and $Cu(DPM)_2$ with the addition of the organic solvent tetrahydrofuran (abbreviated as THF) represented by the chemical formula:

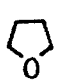

Firstly, the cylinders 21, 23 and 25 were charged with starting materials $Y(DPM)_3.(THF)_n$, $Ba(THF)_2.(THF)_n$ and $Cu(DPM)_2.(THF)_n$ respectively, and their internal temperatures were maintained near 160°C, 280°C and 150°C to convert the staring materials to gases. The flowrate of carrier gas (Ar) in cylinders 21, 23 and 25 was set at 200 cc/min, 300 cc/min and 200 cc/min respectively, and the flowrate of $O_2$ gas was set at 200 cc/min. n is any integer, and need not be any greater than 10.

The gases from the cylinders 21, 23 and 25, together with $O_2$ gas, were introduced into growth tank 11, and a superconducting film was grown on the (100) surface of a substrate 17 consisting of MgO at a temperature (substrate temperature) of 600°C for 30min. The other growth conditions were the same as those of Embodiment 1. The film thus grown was very flat and smooth, similarly to the film in Embodiment 1. Its resistance - temperature characteristics are shown by curve (b) in Fig. and its resistance became zero in the region of 80°K.

Embodiment 3

In place of the organic solvent tetrahydrofuran (THF), dimethylformamide (abbreviated as DMF) and represented by the chemical structure $HCON(CH_3)_2$ was used to obtain starting materials $Y(DPM)_3.(DMF)_n$, $Ba(DPM)_2.(DMF)_n$ and $Cu(DPM)_2.(DMF)_n$. A film with good properties was obtained under very similar growth conditions to those in which THF was used. n is any integer, and need not be greater than 10.

In addition, the materials used in Embodiments 1, 2 and 3 above can be mixed. That is, one can use any combination of one or more of the substances $Y(DPM)_3$, $Y(DPM)_3.(THF)_n$ and $Y(DPM)_3.(DMF)_n$ as the Y starting material; one or more of the substances $Ba(DPM)_2$, $Ba(DPM)_2.(THF)_n$ and $Ba(DPM)_2.(DMF)_n$ as the Ba starting material; and one or more of the substances $Cu(DPM)_2$, $Cu(DPM)_2.(THF)_n$ and $Cu(DPM)_2.(DMF)_n$ as the Cu starting material. In these cases, it is still possible to form an oxide superconducting film with good properties

Embodiment 4

Embodiment 4 of forming an oxide superconducting film in this invention will now be described with reference to Fig. 4. Fig. 4 is a block diagram of the structure of a suitable CVD apparatus for forming the film in this embodiment.

In this method, light is made to irradiate the upper side of the substrate in growth tank 11, thereby optically exciting the starting material gases and the substrate surface. Apart from this optical excitation, the remaining details of the method are the same as those of Embodiment 1 and Embodiment 3, and their description will therefore be omitted.

In Fig. 4, an optical source 43 is installed outside growth tank 11 facing substrate 17. This optical source may be a lamp such as a mercury or xenon lamp, or a laser such as an eximer or argon laser. This optical source need not be limited to a single wavelength, but may contain lights of different wavelengths, and it may also be so designed that it can emit these different wavelengths separately. If an optical source capable of emitting different wavelengths is used, the starting material gas can be irradiated with a wavelength that easily excites the the gas and the gas molecules adsorbed onto the substrate surface, and the chemical reaction is thereby promoted.

In the method of Embodiment 4, the oxide

superconducting film is formed in the same way as in Embodiments 1 - 3. Since the chemical reaction is promoted due to excitation of the starting material gas and the gas molecules adsorbed by the substrate surface, however, the film can be grown when the surface temperature, i.e. the temperature inside the growth tank, is lower than in the case where there is no optical irradiation, and damage to the substrate and film is thereby less.

Embodiment 5

The Embodiment 5 of forming an oxide superconducting film in this invention will now be described with reference to Fig. 5. Fig. 5 is a block diagram of the structure of a suitable CVD apparatus for forming the film in this embodiment.

In Embodiment 5, growth tank 11 is covered with an electric furnace 53 so that the atmosphere inside can be raised to a high temperature. It is also desirable that susceptor 55 upon which substrate 17 is mounted can also be heated so as to heat the substrate, for example by means of a resistance heater.

In this embodiment, the heating of substrate 17 is carried out by an electric furnace 53 and the susceptor 55 consisting of a resistance heater. The other details are the same as in Embodiments 1-3, and will therefore be omitted.

Embodiment 6

Embodiment 6 of forming an oxide superconducting film in this invention will now be described with reference to Fig. 6. Fig. 6 is a block diagram of the structure of a suitable CVD apparatus for forming the film in this embodiment.

In Embodiment 6, substrate 17 is heated by infra-red radiation. Apart from the use of infra-red heating, the other details of the method and the construction of the apparatus are the same as in Embodiments 1 - 3, and will therefore be omitted.

In Fig. 6, 61 is an infra-red lamp, 63 is a power supply for driving the infra-red lamp, and 65 is a collimator for infra-red radiation. Infra-red radiation is collimated by collimator 65 on substrate 17, and substrate 17, is thereby heated. The temperature of substrate 17 is monitored by a thermocouple 19, and the drive power supply 63 is controlled by the signal output from the thermocouple.

Embodiment 7

Embodiment 7 of forming an oxide superconducting film in this invention will now be described with reference to Fig. 7. Fig. 7 is a block diagram of the structure of a suitable CVD apparatus for forming the film in this embodiment.

In Embodiment 7, the opening and shutting of several valves 33 in the diagram, is automatically controlled by a computer 71. In the example shown the operations performed manually in Embodiment 1 are automated. Apart from the use of computer control, the other details of the method and construction are the same as in Embodiments 1 - 3, and are therefore omitted.

In this method, the growth of the desired film is controlled automatically by the program input in computer 71, e.g. the order of opening of the valves, the times during which the valves are open or shut, and the number of times of opening or shutting.

Although not shown in Fig. 7, a light source can of course also be provided to excite the starting material gases in the apparatus, and the film grown while irradiating them with light.

Embodiment 8

Embodiment 8 of forming an oxide superconducting film in this invention will now be described with reference to Fig. 8A and Fig. 8B. Fig. 8A and Fig. 8B are intended to explain Embodiment 8, and show mainly the growth tank 11 and gas ducts leading to the tank.

In this embodiment, oxygen gas is ozonized or converted to radicals in order to promote the chemical reaction of CVD, and to grow the film efficiently. Apart from ozonization, the other other details of the method and the construction of the apparatus are the same as in Embodiments 1 - 3, and will therefore be omitted.

In Fig. 8A, 31 is an oxygen gas supply duct as already mentioned. A high frequency (RF) heating coil 81 is wound around the outer circumference of duct 31 near growth tank 11. 83 is the high frequency heating coil power supply. In this construction, oxygen is converted to plasma, ozone is generated, and this ozone is supplied to growth tank 11.

In the example shown in Fig. 8B, infra-red radiation 91 is allowed to irradiate oxygen supply duct 41 to generate ozone, which is supplied to growth tank 11.

The generation of ozone may be either continuous or intermittent, but should be carried out as convenient depending on the conditions of formation of the film.

The method of this Embodiment 8 also effective in reducing the temperature of the growth tank.

It is also clear that two or more of the methods described in the above embodiment may be used in combination to form the oxide superconducting film more effectively.

In the above embodiment, a film of the type Y-Ba-Cu-O if formed. Good results are however also obtained if Y(yttrium) is replaced by one element M from the list La, Nd, Pm, Sm, Eu, Er, Gd, Tb, Dy, Ho, Tm, Yb, Lu; the starting material gas is $M(DPM)_3$, $M(DPM)_3.(THF)_n$ or $M(DPM)_3.(DPM)_n$; and the growth conditions are the same as those in the above Embodiments 1 - 3.

Further, in the above embodiments, $O_3$ gas or $N_2O$ gas may be used in place of $O_2$ gas, or a combination of two or more of the gases $O_2$, $O_3$ and $N_2O$.

As is clear from the above description, the method of this invention gives an oxide superconducting film with an extremely flat, smooth surface and good superconducting properties, and there is less damage to the substrate or film formed than with physical methods of formation such as the sputter method. As a result, these is very little damage to, for example, the surface of the insulating layer which constitutes the weak coupling of a Josephson element, and contact surfaces with few defects can

thus be obtained.

Further, by choosing the type of starting material gases, and by varying the conditions of supply, order of supply and film growth conditions, it is possible to obtain a film of any desired composition and crystalline structure.

Further, when growing an oxide superconducting film by the CVD method, the film growth speed can be adjusted such that the superconducting thin film is grown one molecular layer at a time. It is thus possible to control the growth of the film such that it corresponds to, for example, the coherence length of a superconductor.

**Claims**

1. A process for forming a superconducting film using chemical vapor deposition, wherein providing as the starting material gas sources
at least one of the compounds $Ba(DPM)_2$, $Ba(DPM)_2.(THF)_n$ or $Ba(DPM)_2.(DMF)_n$,
at least one of the compounds $Cu(DPM)_2$, $Cu(DPM)_2.(THF)_n$ or $Cu(DPM)_2.(DMF)_n$, and
at least one of the compounds $M(DMP)_3$, $M(DPM)_3.(THF)_n$ or $M(DPM)_3.(DMF)_n$, where:
DMP is 2,2,6,6-tetramethyl-3,5-heptaneodianate represented by the chemical formula:
$CH_3C(CH_3)_2COCHCOC(CH_3)_2CH_3$,
THF is tetrahydrofuran represented by the chemical formula:

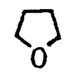

DMF is dimethylformamide represented by the chemical formula:
$HCON(CH_3)_2$
M is an element chosen from the list:
Y, La, Nd, Pm, Sm, Eu, Er, Gd, Tb, Dy, Ho, Tm, Yb, Lu,
and n is any integer,
introducing said starting material gas sources into a growth tank after gasification.
simultaneously introducing at least one of the gases $O_2$, $O_3$, or $N_2O$, and the oxide film being formed on a substrate placed into said growth tank,
whereby an oxide superconducting film is formed on a substrate placed in said growth tank.

2. A process according to claim 1, wherein the substrate upon which said semiconductor film is grown is preheated.

3. A process according to claim 1, wherein each of said gases introduced into the growth tank are irradiated with light.

4. A process according to claim 1, wherein part or all of the $O_2$ gas in the above starting material gases is ozonized.

5. A process according to claim 1, wherein the growth of the semiconductor film in said CVD method is carried out under conditions that permit it to form one molecular layer at a time.

FIG. 1

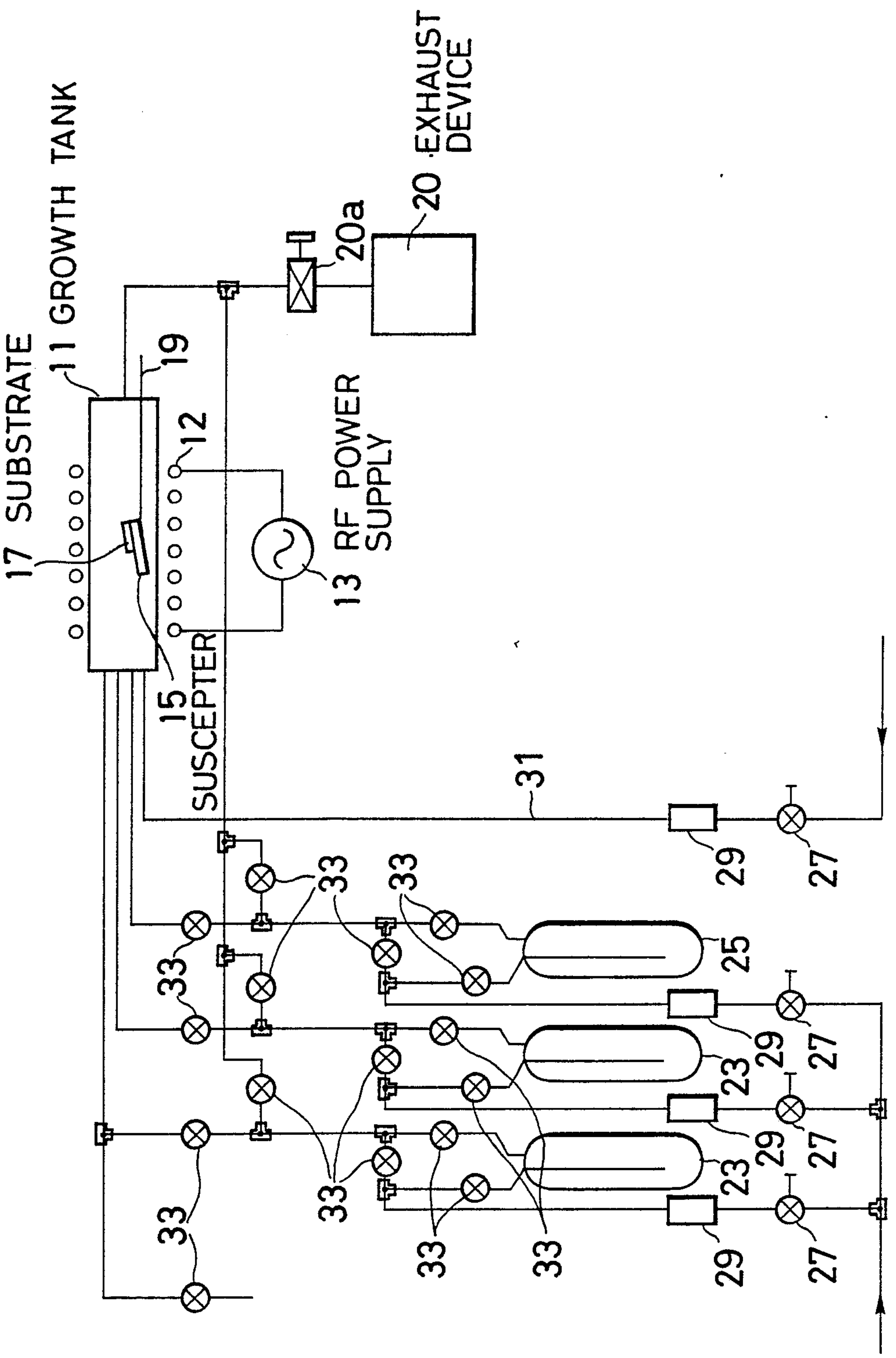

11 GROWTH TANK
17 SUBSTRATE
19
12
13 RF POWER SUPPLY
15 SUSCEPTER
20a
20 EXHAUST DEVICE
31
33
25
23
29
27

FIG.2A

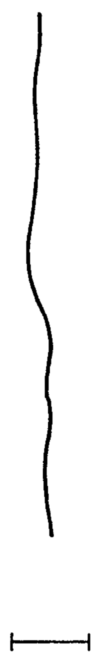


FIG.2B

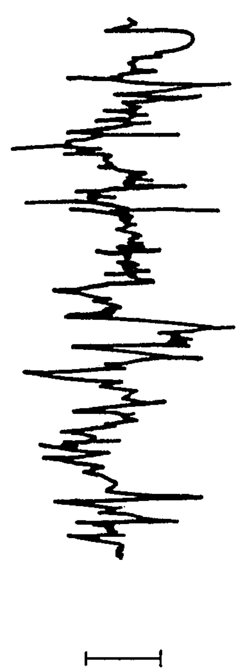

FIG.3

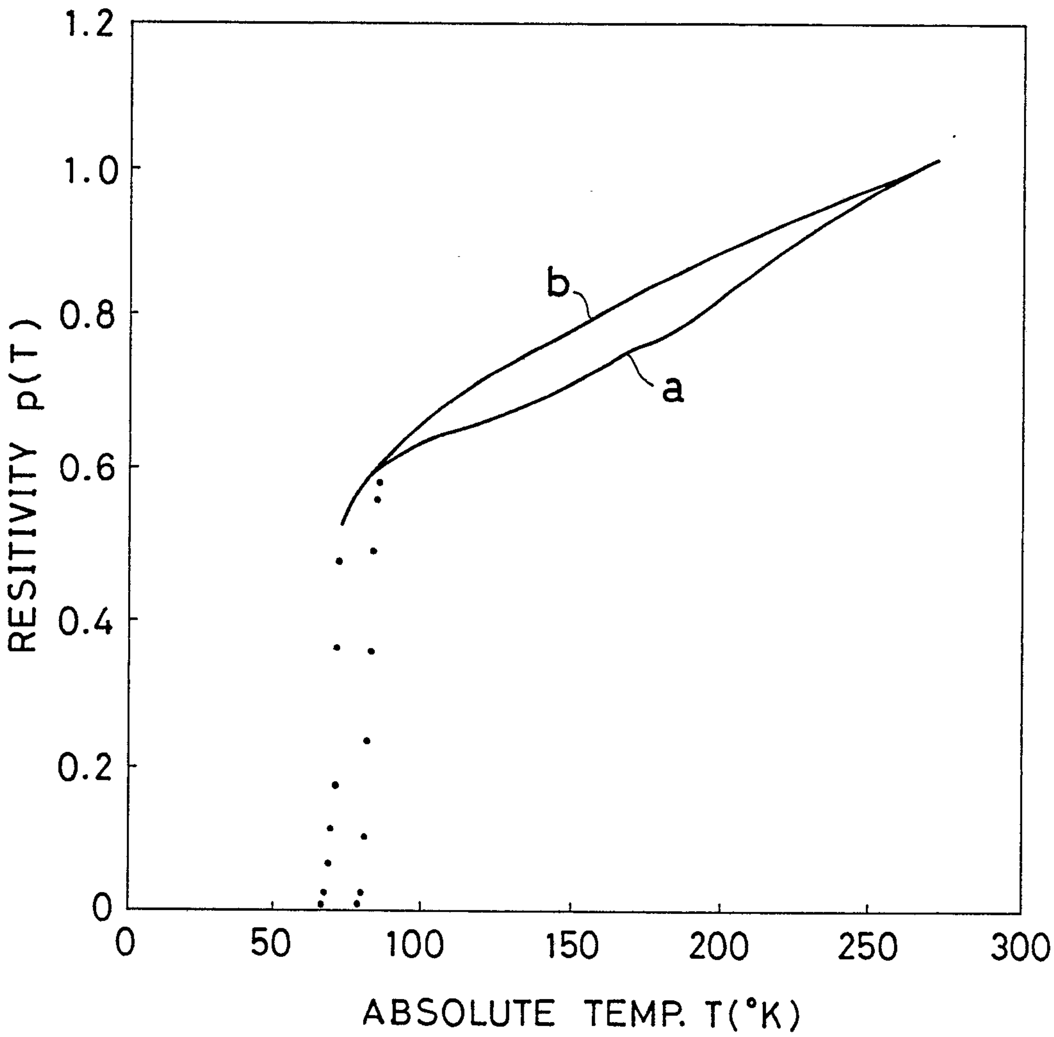
1.2
1.0
0.8
0.6
0.4
0.2
0
RESITIVITY p(T)
0
50
100
150
200
250
300
ABSOLUTE TEMP. T(°K)
a
b

FIG.4

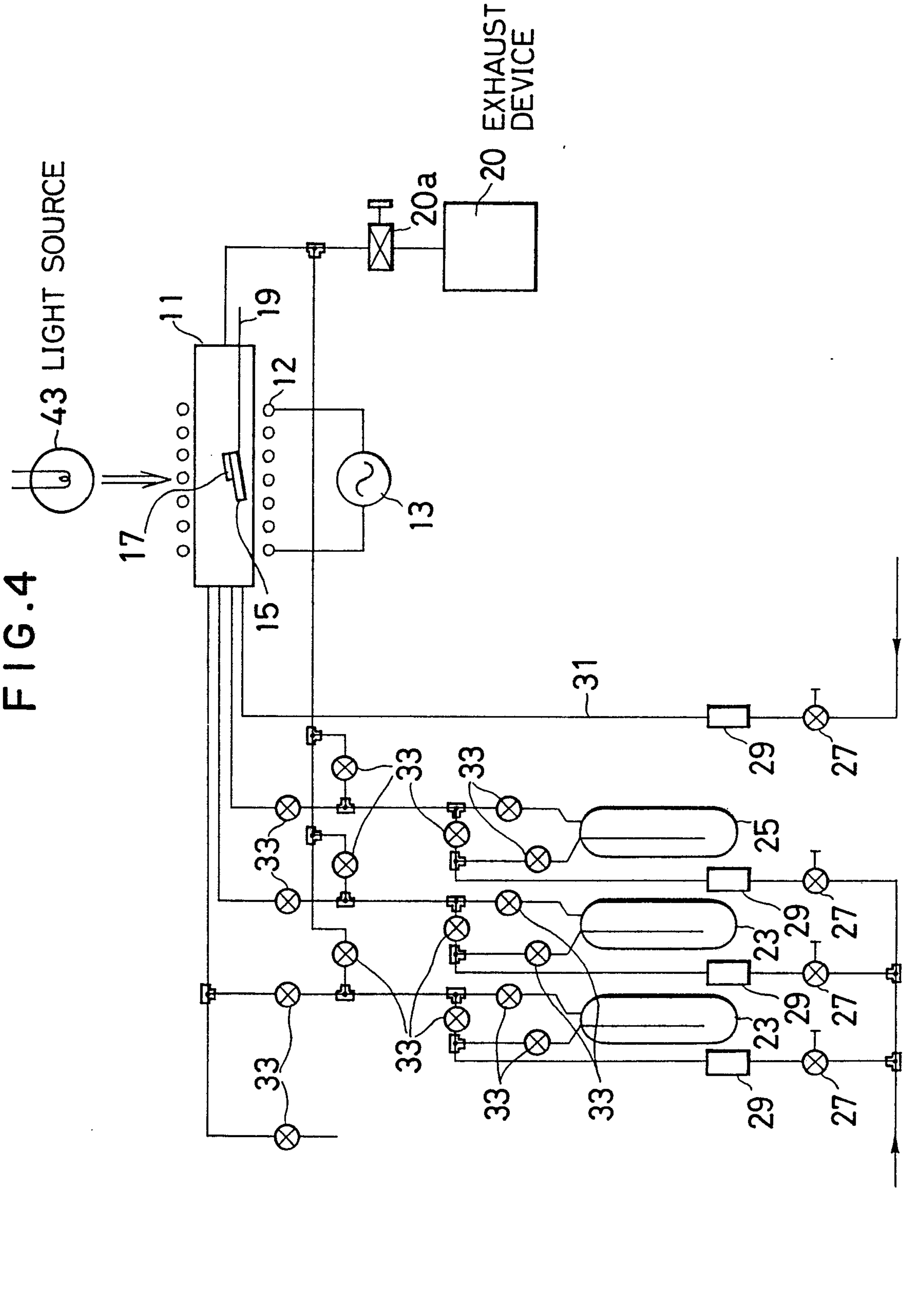

43 LIGHT SOURCE
EXHAUST DEVICE
20
20a
11
19
12
13
17
15
31
29
27
33
25
23

FIG.5

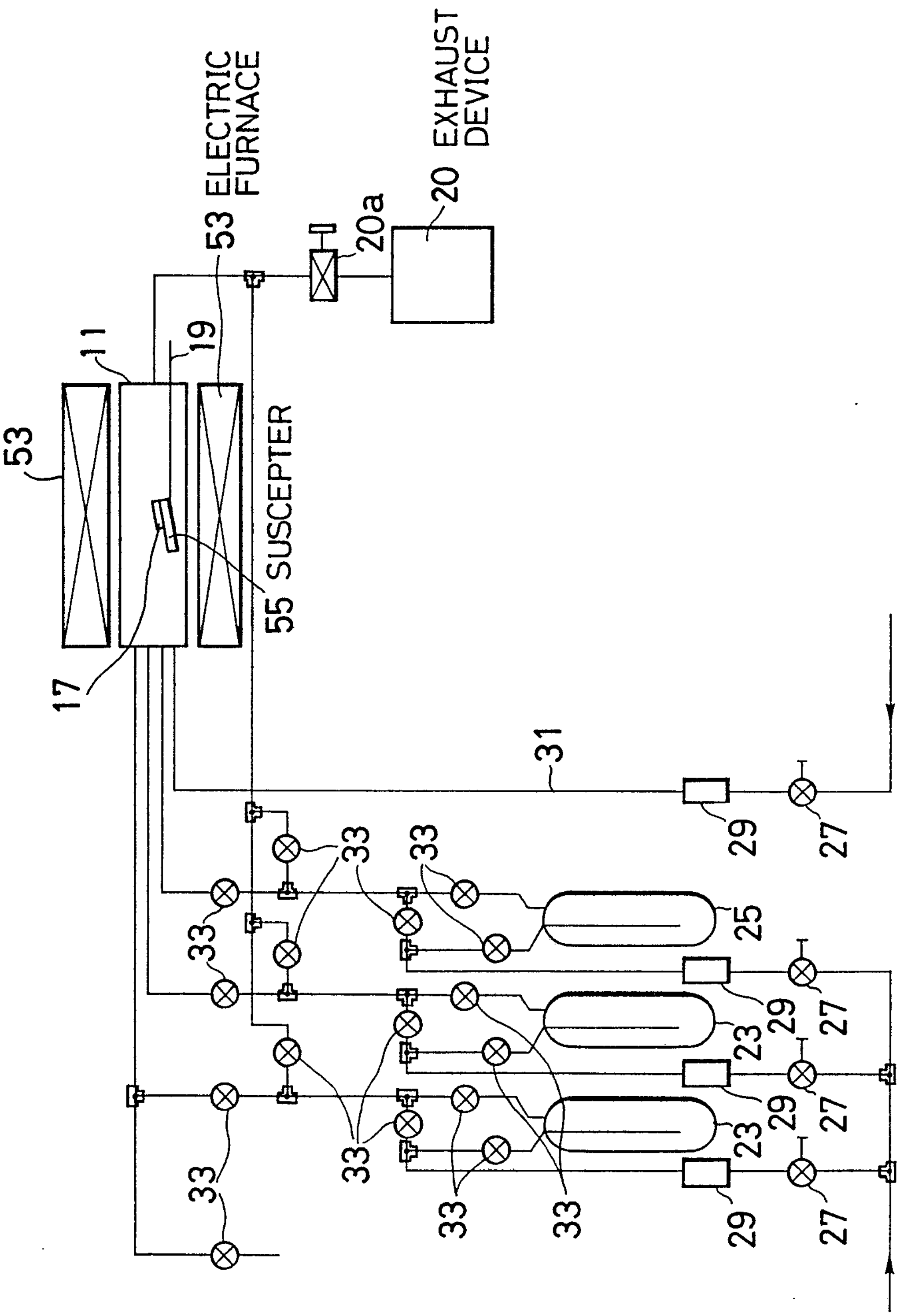
53
11
19
53
ELECTRIC
FURNACE
20a
20
EXHAUST
DEVICE
SUSCEPTER
55
17
31
29
27
33
25
23
23
29
27
29
27
29
27
33
33
33
33
33
33
33
33

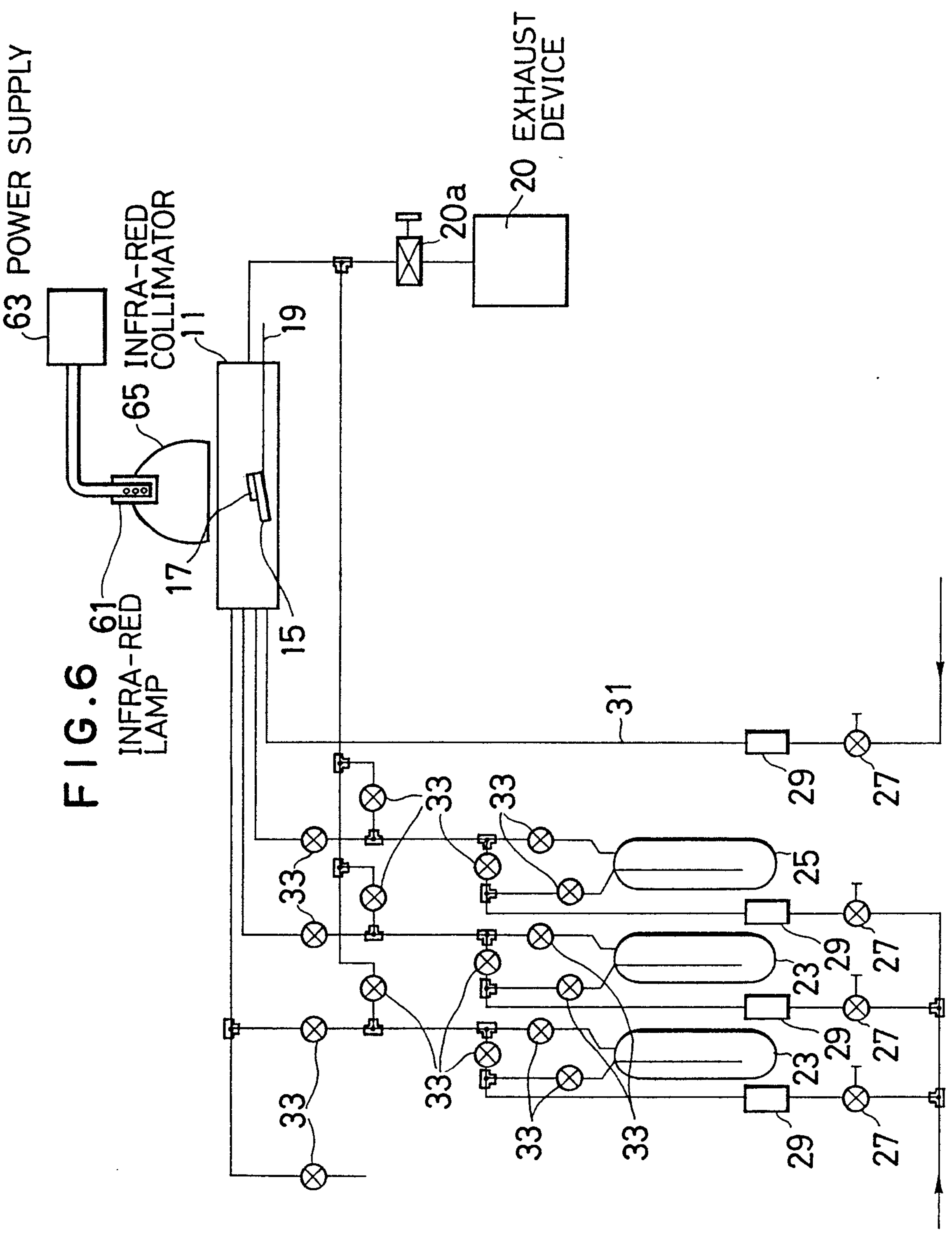
63 POWER SUPPLY
65
61 INFRA-RED LAMP
11 INFRA-RED COLLIMATOR
17
15
19
20a
20 EXHAUST DEVICE
31
29
27
33
25
23

FIG.6

FIG.7

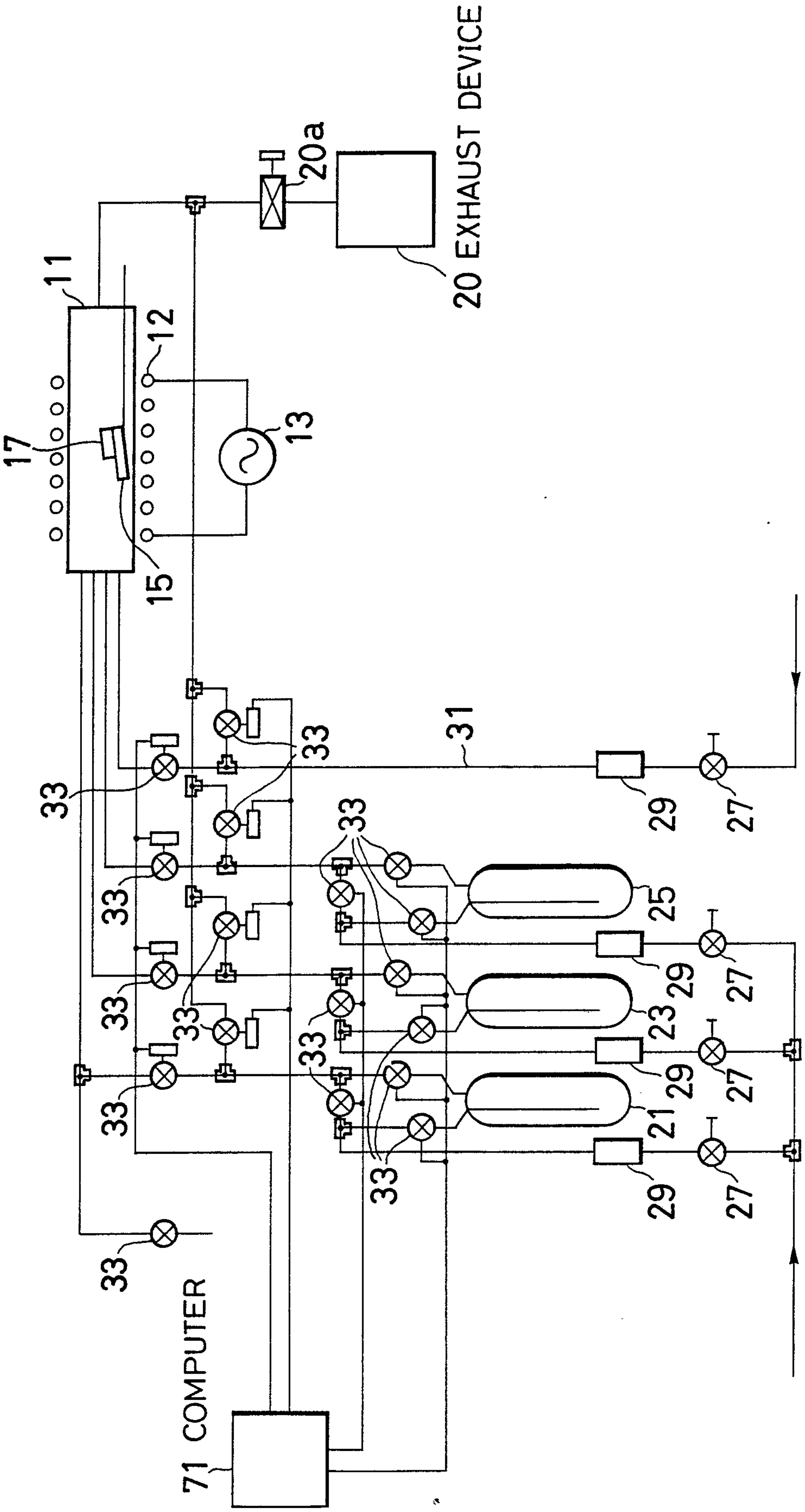

20 EXHAUST DEVICE
20a
11
12
13
15
17
31
33
29
27
25
23
21
71 COMPUTER

FIG.8A

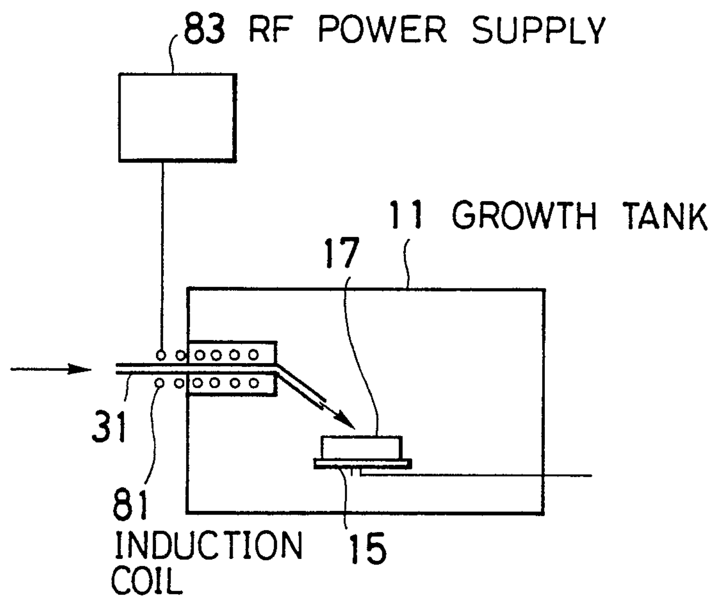
83 RF POWER SUPPLY
11 GROWTH TANK
17
31
81
INDUCTION
COIL
15

FIG.8B

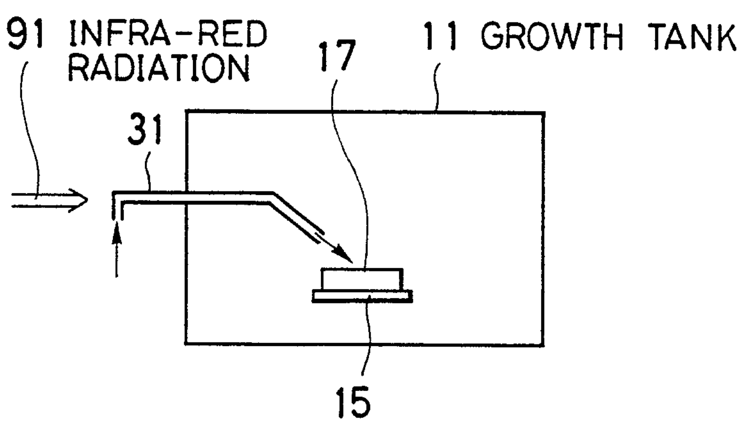
91 INFRA-RED
RADIATION
17
11 GROWTH TANK
31
15